(19) **Europäisches Patentamt**

**European Patent Office**

**Office européen des brevets**

(11) **EP 1 235 190 B1**

(12) **EUROPÄISCHE PATENTSCHRIFT**

(45) Veröffentlichungstag und Bekanntmachung des Hinweises auf die Patenterteilung:
**05.01.2005 Patentblatt 2005/01**

(51) Int Cl.⁷: $G07C\ 9/00$, $E05B\ 65/20$

(21) Anmeldenummer: **02003806.3**

(22) Anmeldetag: **20.02.2002**

(54) **Schlüssellose Betätigungs und/oder Schliesseinrichtung**

Keyless actuating and/or locking device

Dispositif de commande et/ou de verrouillage sans clé

(84) Benannte Vertragsstaaten:
**DE ES FR GB IT**

(30) Priorität: **21.02.2001 DE 10108354**
**05.07.2001 DE 10132077**
**20.02.2002 DE 10207167**

(43) Veröffentlichungstag der Anmeldung:
**28.08.2002 Patentblatt 2002/35**

(73) Patentinhaber: **Kiekert Aktiengesellschaft**
**42579 Heiligenhaus (DE)**

(72) Erfinder:
• **Sandau, Helmut, Dipl.-Ingenieur**
**42549 Velbert (DE)**

• **Gerdes, Bernd, Diplom-Ingenieur**
**45357 Essen (DE)**
• **van Gastel, Peter**
**D-40699 Erkrath (DE)**
• **Lindic, Iko**
**45149 Essen (DE)**

(74) Vertreter: **Nunnenkamp, Jörg, Dr. et al**
**Andrejewski, Honke & Sozien**
**Patentanwälte**
**Theaterplatz 3**
**45127 Essen (DE)**

(56) Entgegenhaltungen:
**WO-A-99/19585**       **DE-A- 19 617 038**
**DE-A- 19 620 059**

**Beschreibung**

Die Erfindung betrifft eine schlüssellose Betätigungs- und/oder Schließeinrichtung für insbesondere Kraftfahrzeuge, mit einem bedienerspezifischen Datenträger, welcher zur Beaufschlagung einer Tür, Klappe oder dergleichen des Kraftfahrzeuges von einer kraftfahrzeugseitigen Steuereinheit auf seine Berechtigung hin abgefragt wird, und mit einem kapazitiven Sensor, welcher bei Annäherung des Bedieners die Datenabfrage startet, wobei der Start der Datenabfrage durch Abstands- und/oder Flächenänderungen von Elektroden des kapazitiven Sensors erst beim Überschreiten eines vorgegebenen Schwellwertes hervorgerufen wird.

Solche schlüssellosen Betätigungs- und/oder Schließeinrichtungen arbeiten üblicherweise dergestalt, dass von der kraftfahrzeugseitigen Steuereinheit nach Auslösen des (kapazitiven) Sensors der bedienerspezifische Datenträger abgefragt wird. Eine Möglichkeit besteht darin, dass die betreffende Steuereinheit mit dem Datenträger einen Datenaustausch beginnt und auf diese Weise die vom Datenträger gelieferten Daten mit den in der elektrischen Steuereinheit gespeicherten Kennungsdaten vergleicht (vgl. DE 196 17 038 C2).

Ein zutrittswilliger Bediener muss also nicht mehr über einen zu einem Schließzylinder passenden Schlüssel verfügen. Vielmehr entriegelt ihm sein bedienerspezifischer Datenträger schlüssellos das betreffende Kraftfahrzeug (keyless entry).

Um den Datenaustausch bzw. die Datenabfrage zwischen Steuereinheit und bedienerspezifischem Datenträger zu starten, schlägt die zuvor angegebene Lehre nach der DE 196 17 038 C2 nicht nur einen kapazitiven Sensor vor, sondern auch, dass mindestens eine Elektrode des kapazitiven Sensors in die Handhabe integriert ist, wobei eine zweite Elektrode des kapazitiven Sensors im Bereich der Handhabe türseitig als Bestandteil der Türblechkonstruktion angeordnet ist.

Hierdurch wird zwischen den beiden vorgenannten Elektroden ein elektrisches Feld aufgebaut. Die Kapazität des solchermaßen gebildeten Kondensators zwischen den beiden Elektroden lässt sich vom Dielektrikum einer in den Bereich des elektrischen Feldes gelangenden menschlichen Hand verändern und damit sensieren. Anders ausgedrückt, wird ein Kondensator durch die beiden Elektroden, einerseits in der Handhabe, andererseits im Türblech zur Verfügung gestellt, dessen Kapazität sich ändert, wenn eine menschliche Hand zwischen den beiden Elektroden eingeführt wird. Denn durch diesen Vorgang variiert die relative Dielektrizitätskonstante des gebildeten Kondensators und somit seine Kapazität, die wiederum gemessen und für die Auslösung der Datenabfrage ausgewertet werden kann.

Die bekannten Maßnahmen haben sich zwar grundsätzlich bewährt, allerdings ist die Bedienung nicht sehr komfortabel, weil die Hand eines zutrittswilligen Benutzers immer zwischen Handhabe und Türblech gebracht werden muss, um einen einwandfreien Start der Datenabfrage definieren zu können.

Die DE 197 52 974 A1 (US 6 002 341) befasst sich mit einer Türschloss-Steuervorrichtung für Fahrzeuge. Diese verfügt über eine elektrisch mit einer Türschließ-Steuereinheit verbundene Kontaktelektrode zum Erfassen einer Betätigung des Türgriffs durch Kontakt durch einen Benutzer. Zusätzlich ist noch eine Fernsteuereinheit mit einer Elektrode vorgesehen. Wenn der die Fernsteuereinheit tragende Benutzer einen zugehörigen Türgriff betätigt, wird durch den Benutzer eine Kapazitätskopplung zwischen der Kontaktelektrode am Türgriff des Fahrzeuges und der Elektrode in der Fernsteuereinheit hergestellt.

Der Körper des Benutzers fungiert also - wenn man so will - als Dielektrikum zwischen den beiden Elektroden, einerseits am Türgriff und andererseits in der Fernsteuereinheit. Weil sich die Dielektrizitätskonstante zwischen den beiden Elektroden durch Annäherung der Bedienperson ändert, erfährt auch die Kapazität des aus den beiden Elektroden gebildeten Kondensators eine Variation, die ausgewertet werden kann.

Ferner befasst sich der gattungsbildende Stand der Technik im Rahmen der DE 196 20 059 A1 (US 5 880 538) mit einer Schaltungsanordnung zum Entriegeln mindestens eines Türschlosses eines Kraftfahrzeuges. Zu diesem Zweck ist ein als kapazitiver Näherungsschalter ausgeführtes Betätigungselement in Kombination mit einer Aktivierungsschaltung vorgesehen. Der kapazitive Näherungsschalter schaltet nur dann, wenn sich ein Ansprechkörper einer zugehörigen Ansprechelektrode nähert. Das alles geschieht in Kombination mit der bereits angesprochenen Aktivierungsschaltung, welche auf eine Smart-Card oder einen Transponder zurückgreift.

Schließlich wird im Rahmen der EP 0 954 098 A2 ein Erkennungssystem mit zugehöriger Schaltvorrichtung und mit einem Leiter angesprochen. Dieser Leiter ist Bestandteil eines Kondensators mit variabler Kapazität, die von der Nähe einer Person abhängt. Ein Detektor dient zur Erfassung von Veränderungen in der Kapazität und zum Erzeugen eines Ausgangssignals, welches die Nähe einer Person relativ zum Leiter anzeigt.

Der Detektor verfügt über einen Oszillator, welcher mit dem Leiter und einem Phasenvergleicher gekoppelt ist. Kapazitätsänderungen resultieren also in einer veränderten Schwingungsfrequenz in dem Oszillator, können also auf diese Weise erfasst werden. - Ähnlich geht die US 4 871 204 vor.

Der Erfindung liegt das technische Problem zugrunde, eine schlüssellose Betätigungs- und/oder Schließeinrichtung der eingangs beschriebenen Ausgestaltung so weiter zu bilden, dass bei einfachem und kostengünstigem Aufbau eine komfortable Bedienung gewährleistet ist.

Zur Lösung dieser Aufgabe schlägt die Erfindung bei einer gattungsgemäßen schlüssellosen Betätigungs- und/oder Schließeinrichtung vor, dass der Sensor mit hierauf befindlichen Ladungen ein elektrisches Feld vorgegebener Ausdehnung als Detektionsbereich definiert, innerhalb dessen Kapazitätsänderungen des aus den Elektroden gebildeten Kondensators erfasst werden, und dass der Detektionsbereich einen Auslösebereich umfasst, wobei lediglich innerhalb des Auslösebereiches hervorgerufene Kapazitätsänderungen die Datenabfrage starten.

Im Gegensatz zu der vorbeschriebenen Vorgehensweise nach der DE 196 17 038 C2 und auch der DE 197 52 974 A1 werden also nicht Änderungen der relativen Dielektrizitätskonstante ausgewertet, sondern vielmehr Abstandsänderungen oder Flächenänderungen der Elektroden des nach wie vor kapazitiven Sensors. Selbstverständlich werden auch Abstandsänderungen und Flächenänderungen erfindungsgemäß erfasst.

Im Vergleich zu der DE 196 20 059 A1 und auch der EP 0 954 098 A2 werden Abstands- und/oder Flächenänderungen der Elektroden des Sensors zwar grundsätzlich erfasst, führen aber nur dann zum Start der Datenabfrage, wenn ein vorgegebener Schwellwert (oder mehrere definierte Schwellwerte) überschritten wird. Anders ausgedrückt, führt grundsätzlich jede Annäherung an den Sensor zu korrespondierenden Kapazitätsänderungen. Diese werden jedoch nur dann im Sinne eines Starts der Datenabfrage umgesetzt, wenn beispielsweise ein bestimmter Mindestabstand unterschritten worden ist. Gleiches gilt für eine Mindeständerung der Fläche. Genauso gut kann der Schwellwert auch als erfasste Mindestkapazität(sänderung) festgelegt werden.

Das erreicht die Erfindung im Detail dadurch, dass der Sensor mit hierauf befindlichen Ladungen ein elektrisches Feld vorgegebener Ausdehnung als Detektionsbereich definiert, innerhalb dessen Kapazitätsänderungen grundsätzlich erfasst werden, wobei der Detektionsbereich den Auslösebereich umfasst. Nur innerhalb des Auslösebereiches hervorgerufene Kapazitätsänderungen starten die Datenabfrage. Dieser Auslösebereich kann zumeist mit einem Mindestabstand der Annäherungen oder einem sogenannten Ansprechabstand identifiziert werden.

In der Regel sind die Elektroden des kapazitiven Sensors einerseits als Leitfähigkeitselektrode und andererseits als sich der Leitfähigkeitselektrode nähernder menschlicher Körper ausgebildet. Dabei geht die Erfindung von der Erkenntnis aus, dass der menschliche Körper in der Regel gegenüber Massepotential oder Erdpotential eine Kapazität von einigen 100 pF aufweist und über das Masse- bzw. Erdpotential einen geschlossenen elektrischen Stromkreis mit der Leitfähigkeitselektrode bildet. Die Erfindung macht also von der Kirchoff'schen-Regel Gebrauch, wonach in einem geschlossenen Stromkreis die Summe aller Spannungsabfälle in einzelnen Maschenelementen gleich Null ist, solange man die Masche im gleichen Sinne durchläuft.

Durch diesen geschlossenen Kreislauf werden elektrische Feld- und damit Ladungs- und Kapazitätsänderungen an der Leitfähigkeitselektrode sensiert, sobald sich beispielsweise eine menschliche Hand eines zutrittswilligen Bedieners der Leitfähigkeitselektrode nähert. Denn diese Hand lässt sich gegenüber der (geladenen) Leitfähigkeitselektrode als Gegenelektrode mit hiervon abweichender Ladung auffassen. Infolgedessen bildet sich zwischen der Leitfähigkeitselektrode und der Hand ein elektrisches Feld, wobei die beim Laden des solchermaßen erzeugten Kondensators verrichtete Arbeit im Kondensator als elektrische Feldenergie gespeichert ist.

Nähert sich nun die Hand als Gegenelektrode der eigentlichen Leitfähigkeitselektrode, so wird ein Teil der gespeicherten elektrischen Feldenergie durch die damit verbundene mechanische Arbeit frei und führt zu einer teilweisen Änderung der Ladung der Leitfähigkeitselektrode, die als (minimaler) elektrischer Stromfluss ausgewertet werden kann.

Diese Abstandsänderungen der Elektroden korrespondieren zu Kapazitätsänderungen des zugehörigen Kondensators im einstelligen pF-Bereich und lassen sich problemlos und einfach auswerten. Hierzu können periodische Lade/Entladevorgänge des betreffenden Kondensators initiiert und hinsichtlich dessen (variierender) Kapazität ausgewertet werden, wie dies in der US 5 730 165 im Detail beschrieben wird.

Üblicherweise wird die Leitfähigkeitselektrode dielektrisch isoliert in einem Handgriff oder einer Handhabe einer zugehörigen Kraftfahrzeugtür angeordnet. Das ist jedoch nicht zwingend, weil die Leitfähigkeitselektrode natürlich auch Bestandteil der Kraftfahrzeugkarosserie im Ganzen sein kann.

Um das von der Leitfähigkeitselektrode und den dort versammelten Ladungsträgern ausgehende elektrische Feld zu bündeln, sieht die Erfindung ferner vor, dieses elektrische Feld zur Kraftfahrzeugaußenseite oder -innenseite hin zu richten und gegebenenfalls abzuschirmen. Das hängt davon ab, ob Annäherungen eines Bedieners an den Handgriff per se zur Auslösung des beschriebenen Dialogs ausgewertet werden sollen oder - wie in der DE 196 17 038 C2 beschrieben - erst die zwischen Handgriff und Türblech eingeführte Hand die Datenabfrage starten soll. Beides ist im Rahmen der erfindungsgemäßen Lehre möglich, so dass sich enorme Variationsmöglichkeiten ergeben.

Schließlich kann noch ein weiterer Sensor zum Sichern des Fahrzeuges vorgesehen sein. Dieser lässt sich durch Vorbeistreichen einer Hand des Bedieners auslösen, wie dies grundsätzlich in der DE 196 17 038 C2 beschrieben ist.

Immer wird eine schlüssellose Betätigungs- und/oder Schließeinrichtung für insbesondere Kraftfahrzeuge zur Verfügung gestellt, die sich durch besonders einfachen und kostengünstigen Aufbau auszeichnet. Denn letztlich erfordert die beschriebene Vorrichtung lediglich die Realisierung einer irgendwo angebrachten Leitfähigkeitselektrode in Kombination mit einer zugehörigen Auswerteelektronik, die vorteilhaft als einziger Chip ausgebildet ist. Die Unter- und Anbringung zweier Elektroden, wie sie der Stand der Technik teilweise für unverzichtbar hält, ist also ausdrücklich nicht erforderlich. Das hat ergänzend natürlich enorme Komfortverbesserungen zur Folge, weil der Bediener nicht an irgendwelche Handlungsabläufe gebunden ist. Es reicht vielmehr aus, dass er (oder seine Hand) sich dem zu öffnenden Kraftfahrzeug nähert, und zwar innerhalb des Auslösebereiches, um die Datenabfrage zu starten. Hierin sind die wesentlichen Vorteile zu sehen.

Im Folgenden wird die Erfindung anhand einer lediglich ein Ausführungsbeispiel darstellenden Zeichnung näher erläutert. Es zeigen:

Fig. 1    eine schlüssellose Betätigungs- und/oder Schließeinrichtung mit ihren wesentlichen Bestandteilen,

Fig. 2    die zugehörige Sensorelektronik,

Fig. 3    die Leitfähigkeitselektrode im Detail in verschiedenen Ausgestaltungen,

Fig. 4    den Gegenstand nach Fig. 1 in Detailansicht in einer ersten Variante,

Fig. 5    den Gegenstand nach Fig. 4 in abgewandelter Ausführungsform,

Fig. 6    prinzipiell den Gegenstand nach Fig. 5 im seitlichen Schnitt,

Fig. 7    eine andere Ausgestaltung des erfindungsgemäßen Türgriffes in Seitenansicht und

Fig. 8    den Türgriff nach Fig. 7 mit Blick entlang der zugehörigen Kraftfahrzeugtür, und zwar aus Fahrtrichtung hinten gesehen nach vorne.

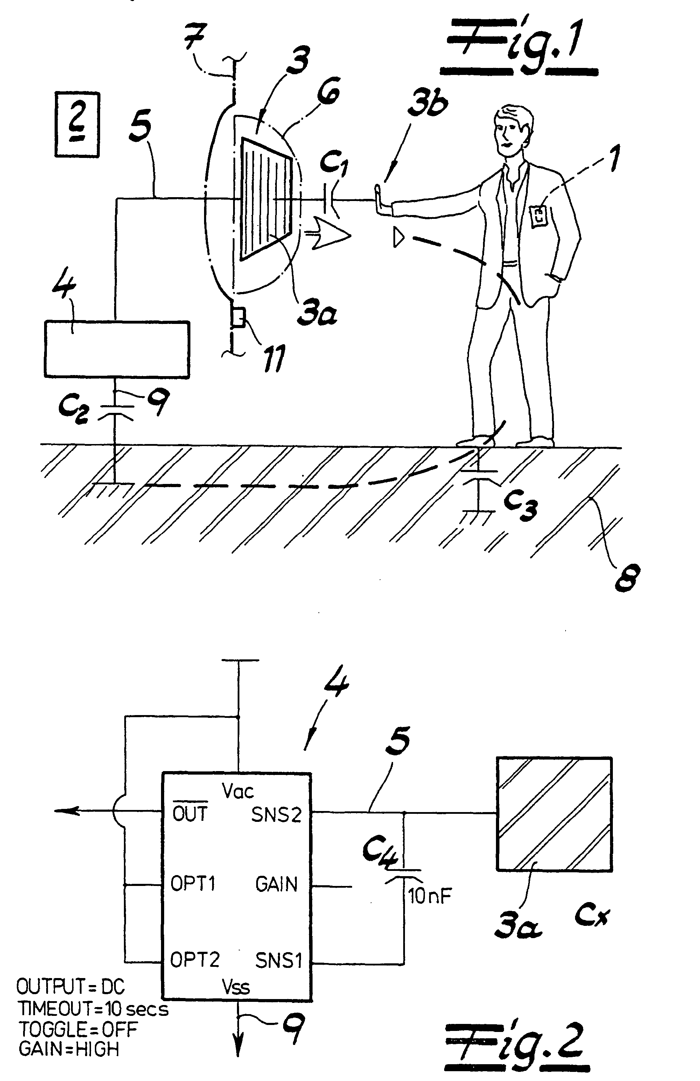

In der Fig. 1 ist eine schlüssellose Betätigungs- und/oder Schließeinrichtung in ihrem grundsätzlichen Aufbau dargestellt. Man erkennt einen zutrittswilligen Bediener, welcher beispielsweise in einer Tasche einen bedienerspezifischen Datenträger 1 trägt. Dieser bedienerspezifische Datenträger 1 wird von einer kraftfahrzeugseitigen Steuereinheit 2 auf die Zutrittsberechtigung der betreffenden Person hin abgefragt. Zu diesem Zweck läuft zumeist ein bidirektionaler Datenaustausch auf elektromagnetischem Weg (d. h. drahtlos) zwischen bedienerspezifischem Datenträger 1 und kraftfahrzeugseitiger Steuereinheit 2 ab, wie dies allgemein bekannt ist und nicht Gegenstand der vorliegenden Erfindung ist.

In diesem Zusammenhang sollte betont werden, dass der bedienerspezifische Datenträger 1 sowohl aktiv als auch passiv arbeiten mag, wobei selbstverständlich auch Kombinationen umfasst werden. Ein aktives Arbeiten des Datenträgers 1 bedeutet, dass dieser zumeist mit einem Energiespeicher ausgerüstet ist und selbstständig Daten aussendet, die von der kraftfahrzeugseitigen Steuereinheit 2 überprüft werden. Bei einem passiven Datenträger 1 erfolgt jedoch hauptsächlich eine Abfrage der dort hinterlegten Daten mit Hilfe der Steuereinheit 2.

Um den vorerwähnten Datenaustausch zu initiieren, ist ein kapazitiver Sensor 3 vorgesehen, welcher bei Annäherung des Bedieners die Datenabfrage startet. Dieser kapazitive Sensor 3 verfügt über zwei Elektroden, nämlich eine Sensorelektrode bzw. Leitfähigkeitselektrode 3a einerseits und eine Hand oder ein anderes sich der Leitfähigkeitselektrode 3a näherndes Teil 3b des menschlichen Körpers andererseits. Bei diesem Teil 3b handelt es sich im Rahmen des Ausführungsbeispiels um die ausgestreckte Hand 3b des betreffenden Bedieners.

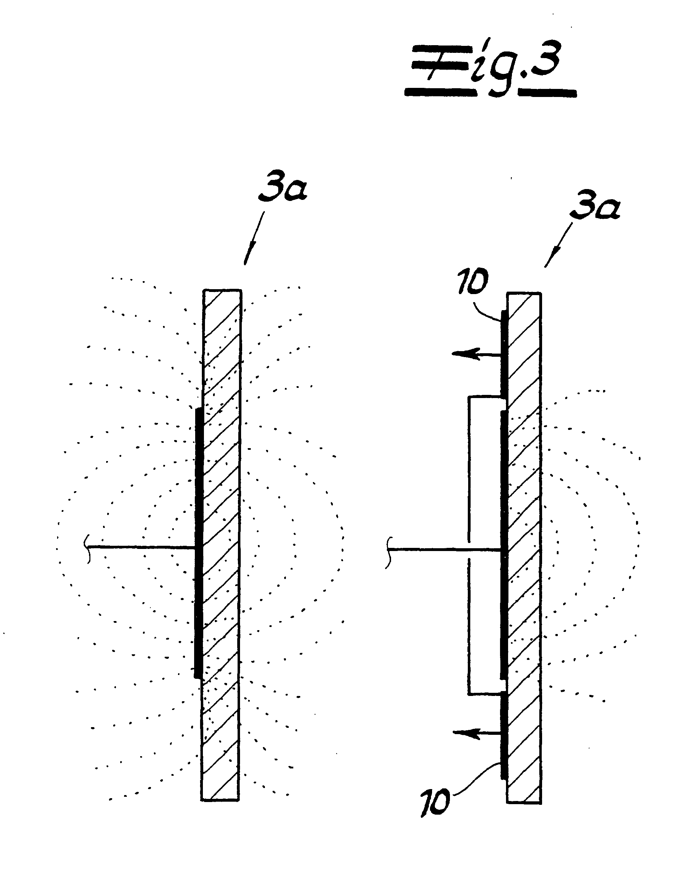

Das Annähern der Hand 3b und damit der zugehörigen Elektrode 3b in Richtung auf die Leitfähigkeitselektrode 3a wird mit Hilfe einer Sensorelektronik 4 ausgewertet, die im Detail in Fig. 2 dargestellt ist. Diese Sensorelektronik 4 steht über eine Zuleitung 5 mit der Leitfähigkeitselektrode 3a in Verbindung, die ihrerseits in einen Handgriff bzw. eine Handhabe 6 eingebettet ist. Mit Hilfe dieses Handgriffes bzw. der Handhabe 6 lässt sich eine zugehörige Kraftfahrzeugtür 7 öffnen, von welcher nur ein Teil dargestellt ist. Zuvor muss jedoch ein die Kraftfahrzeugtür 7 verriegelndes Schloss entriegelt werden, was im Anschluss an die positive Datenabfrage zwischen bedienerspezifischem Datenträger 1 und kraftfahrzeugseitiger Steuereinheit 2 erfolgt.

Im Detail genügt bekanntlich die Kapazität C des Kondensators 3a, 3b der Beziehung:

$$C = \varepsilon \cdot \frac{F}{a},$$

mit $\varepsilon$ der Dielektrizitätskonstante, F der Fläche einer Platte des Kondensators und a dem Abstand der Platten. Bei der vorliegenden Erfindung wird der Abstand a zwischen den beiden Elektroden 3a, 3b und/oder deren Fläche F variiert, so dass sich die Kapazität des Kondensators 3a, 3b entsprechend der angegebenen Vorschrift ändert, und zwar zumeist im pF-Bereich. Dabei hat sich ein Ansprechabstand von ca. 30 mm und weniger zwischen Leitfähigkeitselektrode 3a und Hand 3b (oder anderem angenäherten Körperteil des Bedieners bzw. der Bedienperson) als vorteilhaft erwiesen. Dieser Ansprechabstand korrespondiert zu einem Auslösebereich A, wie mit Bezug zur Fig. 6 noch näher beschrieben wird.

Die vorerwähnten Kapazitäten im pF-Bereich werden von der Sensorelektronik 4 gemessen, die als elektronischer Schaltkreis ausgeführt ist und im Rahmen des Ausführungsbeispiels kapazitiv an das Massepotential bzw. Erdpotential 8 gekoppelt ist. Hierzu dient eine Verbindungsleitung 9. Auch die Bedienperson ist mit dem Masse- bzw. Erdpotential 8 kapazitiv gekoppelt, was durch jeweils angedeutete Kondensatoren $C_2$, $C_3$ im Vergleich zum Kondensator $C_1$, gebildet durch die Elektroden 3a, 3b, angedeutet ist.

Auf diese Weise entsteht ein geschlossener elektrischer Stromkreis, so dass Kapazitätsänderungen des Kondensators $C_1$ problemlos mit Hilfe der Sensorelektronik 4 ausgewertet werden können. Hierzu dienen periodische Lade-/Entladevorgänge des Kondensators 3a, 3b bzw. der Leitfähigkeitselektrode 3a, die die Sensorelektronik 4 überwacht und auswertet.

Durch Annäherungen der Bedienperson ändern sich die ermittelten Auflade- und/oder Entladezeiten des Kondenstators 3a, 3b im Vergleich zu der Referenzzeitspanne. Der betreffende Zeitunterschied kann gemessen werden und repräsentiert im Kern die dahinterstehende Änderung der Kapazität des Kondensators 3a, 3b. Sobald der Zeitunterschied (und damit die Kapazitätsänderung) des kapazitiven Sensors 3 einen üblicherweise von der Sensorelektronik 4 vorgegebenen Schwellwert überschreitet, wird die Datenabfrage gestartet.

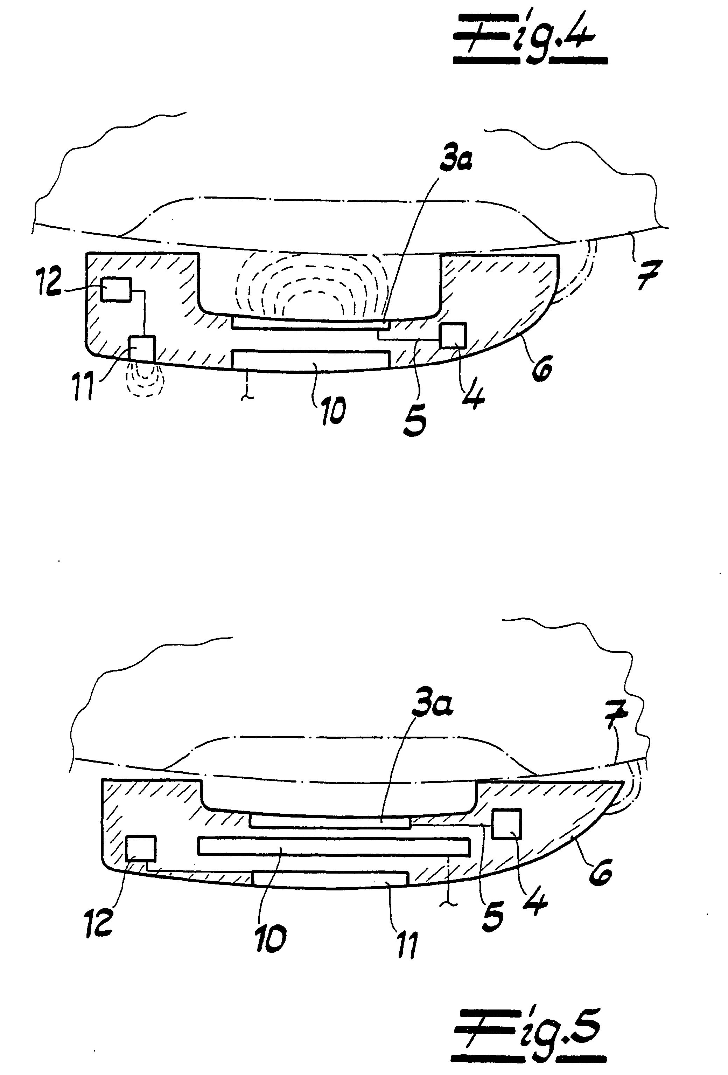

Die Elektrode 3a bzw. Leitfähigkeitselektrode 3a mag als Gitter- oder Flächenelektrode ausgeführt sein und bedienerseitig mit einem Dielektrikum zur Isolierung belegt sein. Zusätzlich sind Abschirmungen denkbar, wie sie in Fig. 3 im rechten Teil zu erkennen sind. Hierdurch wird gewährleistet, dass die auf der Leitfähigkeitselektrode 3a befindlichen Ladungen ein vom Kraftfahrzeug bzw. der Kraftfahrzeugtür 7 weg gerichtetes elektrisches Feld formen. Dazu dienen geerdete Abschirmbleche 10.

Ein Kondensator $C_4$ sorgt für eine Glättung des eingangsseitigen Signals von der Leitfähigkeitselektrode 3a. Mit dessen Hilfe kann das Ansprechverhalten verändert werden. Ein Sensor 11 dient zum Sichern (Verriegeln) des Fahrzeuges. Dieser lässt sich beispielsweise durch Vorüberstreichen einer Hand des Bedieners auslösen.

Im Rahmen der Fig. 4 erkennt man die Leitfähigkeitselektrode 3a, angeordnet in der Handhabe 6 in Aufsicht. Diese Handhabe 6 dient bekanntermaßen zur Öffnung der Kraftfahrzeugtür 7. In Folge einer Abschirmung 10, die beispielsweise auf Masse- oder Erdpotential 8 liegt, bilden sich zugehörige Feldlinien von der Leitfähigkeitselektrode 3a ausgehend lediglich in Richtung auf die Kraftfahrzeugtür 7 aus. Dementsprechend muss in diesem Fall die Gegenelektrode in Gestalt der Hand 3b regelmäßig in den Bereich zwischen Handgriff 6 und Kraftfahrzeugtür 7 gebracht werden, um den gewünschten Effekt zu erzielen.

Die zugehörige Sensorelektronik 4 ist - wie die Leitfähigkeitselektrode 3a - in den Handgriff bzw. die Handhabe 6 eingebettet. Sie passt sich der Umgebung an, ist also als intelligente Elektronik ausgeführt. Hierunter versteht der Erfindungsgedanke, dass insbesondere Änderungen der Kapazitäten $C_1$, $C_2$ und $C_3$ entsprechend Fig. 1 fortlaufend Berücksichtigung finden.

Das heißt nichts anderes, als dass beispielsweise die Ankopplung der Sensorelektronik 4 wie auch der Bedienperson an das Massepotential 8 naturgemäß Schwankungen schon aufgrund des Wetters und der damit verbundenen Luftfeuchte unterworfen ist. Gleiches gilt für die Kapazität $C_1$ aus den Elektroden 3a, 3b. Diesen Variationen trägt die Sensorelektronik 4 Rechnung. Das gelingt im Kern dadurch dass die Kapazitäten $C_2$ und $C_3$ natürlich auch Einfluss auf die gemessene Kapazität $C_1$ haben. Deren umweltbedingte Änderungen (d. h. der Kapazitäten $C_1$, $C_2$, $C_3$) spielen sich jedoch - im Vergleich zur Annäherung einer Bedienperson - auf ganz anderen (längeren) Zeitskalen ab und können demzufolge von den Annäherungen der Hand 3b an die Leitfähigkeitselektrode 3a unterschieden werden.

Tatsächlich führen Umwelteinflüsse wie Regen, wechselnde Temperaturen oder dergleichen zu Änderungen der Kapazität des Kondensators 3a, 3b, die von Annäherungen der Bedienperson unterschieden werden müssen. Um diese Umwelteffekte zu kompensieren, schlägt die Erfindung vor, durch Umwelteinflüsse bedingte Kapazitätsänderungen des Sensors 3 bzw. Kondensators 3a, 3b zu erfassen und eine Rekalibrierung der Referenzzeitspanne vorzunehmen. Diese Rekalibrierung wird in bestimmten vorgegebenen Zeitspannen durchgeführt, z. B. alle 100 msec. bis 200 msec.. Durch diese turnusgemäße und in schnellen Abständen folgende Neufestlegung der jeweiligen Referenzzeitspanne wird sichergestellt, dass innerhalb der Zeitspanne für die Rekalibrierung Umwelteinflüsse praktisch keine Rolle spielen und Kapazitätsänderungen demzufolge zutreffend als Annäherung der Bedienperson ausgewertet werden.

Bei dem Sensor 11 handelt es sich im Rahmen der Ausführungsbeispiele nach den Fig. 4, 5 und 7 um einen Annäherungssensor. Selbstverständlich kann an dieser Stelle auch ein Taster zum Einsatz kommen. Im Rahmen der dargestellten Variante ist der Sensor 11 ähnlich ausgeführt und aufgebaut, wie die Leitfähigkeitselektrode 3a. Das deutet das von dem Sensor 11 ausgehende elektrische Feld nach Fig. 4 an, welches - wie bei der Leitfähigkeitselektrode 3a - von darauf befindlichen freien elektrischen Ladungen hervorgerufen wird.

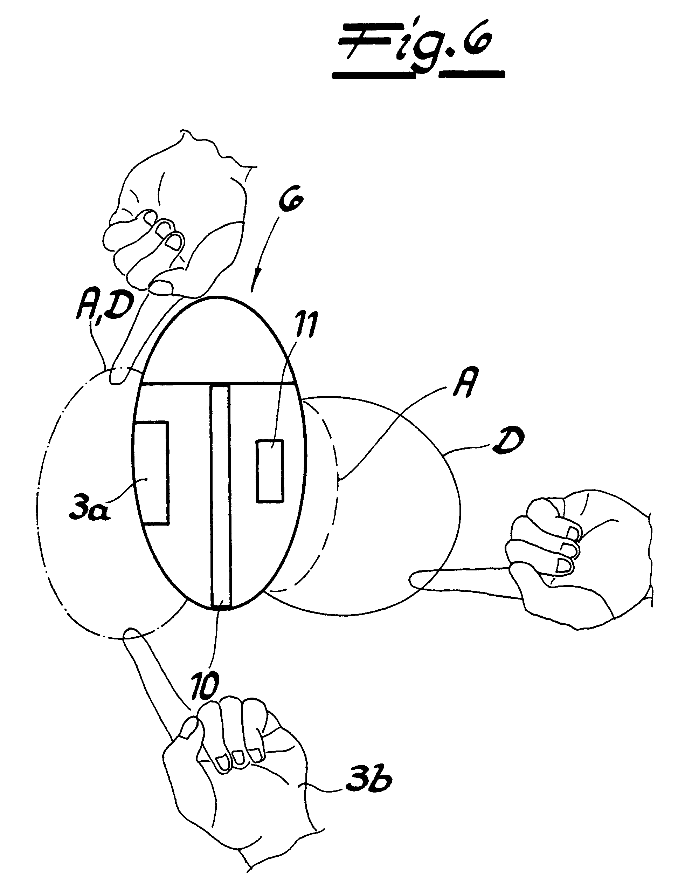

Eine Annäherung beispielsweise der Hand 3b an den Sensor 11 wird in vergleichbarer Weise von einer zugehörigen zweiten Sensorelektronik 12 ähnlich ausgewertet, wie dies bereits die erste Sensorelektronik 4 vornimmt. Sobald eine Annäherung detektiert wird, geben die entsprechenden Elektroniken 4, 12 ein Ausgangssignal an die kraftfahrzeugseitige Steuereinheit 2 ab. Das geschieht zumeist drahtgebunden über in den Fig. 4 und 5 lediglich angedeutete strichpunktierte Zuleitungen von der Handhabe 6 zur Kraftfahrzeugtür 7. Selbstverständlich ist auch eine drahtlose Kommunikation zwischen den Elektroniken 4, 12 und der Steuereinheit 2 denkbar. Auch liegt es zweifellos im Rahmen der Erfindung, beide Elektroniken 4, 12 zu einer Einheit zusammenzufassen. Schließlich können grundsätzlich auch beide Sensoren 3a, 11 eine Einheit bilden.

Darüber hinaus eröffnet die Erfindung die Möglichkeit, zwischen einem simplen Entriegeln eines zugehörigen Türschlosses und damit der Kraftfahrzeugtür 7 und einem elektrischen Öffnen des Schlosses bzw. der Kraftfahrzeugtür 7 zu unterscheiden. Zum Entriegeln des Türschlosses genügt in der Regel die beschriebene Annäherung der Hand 3b an die Leitfähigkeitselektrode 3a. Soll nun zusätzlich noch das Türschloss elektrisch geöffnet und ferner ggf. die Tür ausgestellt werden, so lässt sich dies dadurch realisieren, dass im Anschluss an die Annäherung der Hand 3b diese über die Leitfähigkeitselektrode 3a streicht, so dass zwei unterschiedliche Signale ausgewertet und getrennt voneinander verarbeitet werden können.

Im Rahmen der Variante nach Fig. 5 sorgt eine zwischen der Leitfähigkeitselektrode 3a und dem Sensor 11 befindliche Abschirmung 10 dafür, dass die von beiden Einrichtungen 3a, 11 jeweils ausgehenden elektrischen Felder entgegengesetzt gerichtet sind, und zwar einerseits in Richtung auf die Kraftfahrzeugtür 7 (Leitfähigkeitselektrode 3a) und andererseits entgegengesetzt gerichtet hierzu (Sensor 11). Bei der Abschirmung 10 bzw. einem zugehörigen Abschirmblech 10 kann es sich sowohl um eine Metallplatte als auch eine Kunststofffolie mit Metallbeschichtung oder auch eine simple Metallfolie handeln, die problemlos in die zumeist als Kunststoffspritzgussteil ausgeführte Handhabe 6 eingebracht werden kann.

Anhand der schematischen Schnittdarstellung des Gegenstandes nach Fig. 5 im Rahmen der Fig. 6 lassen sich die von den Sensoren 3, 11 ausgehenden elektrischen Felder erkennen. Diese werden durch auf den Sensoren 3, 11 befindliche Ladungen hervorgerufen und nehmen eine von der Ladung bzw. Ladungsdichte abhängige Gestalt an. Das gebildete elektrische Feld mag sich in kurzen Zeitabständen ändern, weil zur Erfassung der Kapazitätsänderungen der Sensoren 3, 11 Aufladezeiten für einerseits die Leitfähigkeitselektrode 3a und andererseits den Sensor 11 (bei dem es sich ebenfalls um einen kapazitiven Sensor handelt) ermittelt werden. Da das Auf- und Entladen jeweils nicht vollständig erfolgt und innerhalb äußerst kurzer Zeitperioden im Millisekunden-Bereich vonstatten geht, bilden sich gleichsam gemittelte elektrische Felder, wie sie in der Fig. 6 dargestellt sind.

Hier erkennt man einen durchgezogen dargestellten Detektionsbereich D des Sensors 11 sowie einen strichpunktiert gezeigten Detektionsbereich D des Sensors 3 bzw. der Leitfähigkeitselektrode 3a.

Diese jeweiligen Detektionsbereiche D stellen sich im Zeitmittel ein und werden von den auf dem jeweiligen Sensor 3, 11 befindlichen Ladungen vorgegeben. Sobald die Hand 3b in diesen jeweiligen Detektionsbereich D eintaucht, werden hiermit verbundene Abstandsänderungen des Kondensators 3a, 3b als Kapazitätsänderungen von der Auswerteeinheit bzw. Sensorelektronik 4 erfasst. Diese Abstandsänderungen führen jedoch nur dann zum Start der Datenabfrage, wenn die Hand 3b in den Auslösebereich A eintaucht. Der Auslösebereich A liegt innerhalb des Detektionsbereiches D.

Im Rahmen des Ausführungsbeispiels beträgt die Fläche des Auslösebereiches A nur in etwa 1/4 bis 1/5 des Detektionsbereiches D mit Bezug zum Sensor 11. Dagegen decken sich Auslösebereich A und Detektionsbereich D beim Sensor 3a. Es gilt also für die zugehörigen Flächen $F_A$ des Auslösebereiches A und $F_D$ des Detektionsbereiches D:

$$F_A \leq F_D.$$

Auf diese Weise lassen sich Fehlfunktionen größtenteils ausschließen. Dabei versteht sich, dass die jeweiligen Bereiche A, D jeweils von der Auswerteeinheit 4 vorgegeben werden und im Rahmen des Ausführungsbeispiels zu Schwellwerten der Kapazitätsänderung und damit der Variation der Aufladezeit korrespondieren.

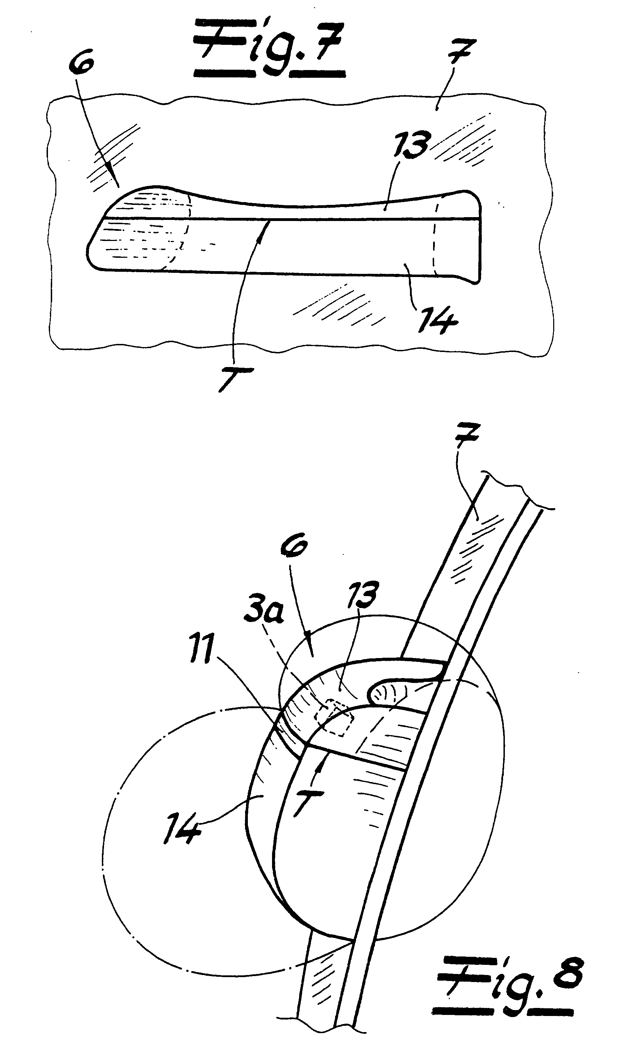

Anhand der Variante nach Fig. 7 erkennt man, dass die Leitfähigkeitselektrode 3a und der Empfangsbereich entsprechend den Fig. 3 und 6 eine Abwandlung dergestalt erfahren können, dass diese Leitfähigkeitselektrode 3a noch mit einer Zusatzelektrode 13 ausgerüstet wird. Das heißt, Leitfähigkeitselektrode 3a und Zusatzelektrode 13 übernehmen praktisch die gleiche Funktion, sind elektrisch miteinander verbunden und sorgen durch ihre topologische Anordnung im Kern lediglich für eine Variation des von der Leitfähigkeitselektrode 3a alleine definierten elektrischen Feldes gemäß Fig. 6.

Bei der Zusatzelektrode 13 mag es sich um eine leitfähige Deckelschale 13 für den Handgriff bzw. die Handhabe 6 handeln, die mit einer zugehörigen Grundschale 14 vereinigt wird. Die Deckelschale 13 lässt sich beispielsweise so leitfähig gestalten, dass hierin ein oder mehrere Leitfähigkeitsbahnen, z. B. Kupferdrähte, eingebettet oder eingelagert werden. Natürlich kann auch eine entsprechende Kunststoffschale galvanisch metallisiert werden. Daneben ist es denkbar, die Zusatzelektrode 13 alternativ oder additiv auch als vom Handgriff 6 unabhängige Zierleiste oder vergleichbar auszuführen.

Deckelschale 13 und Grundschale 14 lassen sich auf bekannte Art miteinander verbinden, beispielsweise durch clipsen, klemmen, kleben, verschrauben etc.. Immer spricht die Leitfähigkeitelektrode 3a ggf. in Verbindung mit der Zusatzelektrode 13 dann an, wenn sich das Teil 3b bzw. die ausgestreckte Hand 3b des betreffenden Bedieners auf eine Distanz von weniger als 6 mm annähert, also in den Auslösebereich A gelangt.

Folglich wirken diese Sensoren 3a, 13 letztlich auf Berührungen, während der Sensor 11 als Näherungssensor mit einem Ansprechabstand von ca. 30 mm ausgeführt ist. Das kommt in der Fig. 8 durch den hier angedeuteten durchgezogenen Reichweitenbereich zum Ausdruck. Im Rahmen der Fig. 8 sind aus Gründen der Einfachheit nur die jeweiligen Detektionsbereiche D der zugehörigen Sensoren 3a, 13 und 11 dargestellt. - Es versteht sich, dass der als Näherungssensor arbeitende Sensor 11 selbstverständlich auch auf Berührungen ansprechen kann. Genauso gut lassen sich die Sensoren 3a, 13 als Näherungssensoren ausbilden. Das ist letztlich eine Frage der Ausdehnung des zugehörigen Detektionsbereiches D und des Auslösebereiches A, wobei die Sensoren 3a, 11 und 13 selbstverständlich ihre Funktionen tauschen können.

Anhand der Fig. 8 erkennt man, dass der gleichsam auf Näherungen reagierende Sensor 11 einen deutlich größeren Empfangsbereich bzw. Detektionsbereich D aufweist. Er spricht bereits an, wenn sich ein zugehöriger Bediener dem Sensor 11 bis auf eine Distanz von einigen Zentimetern, vorzugsweise bis zu 3 cm, nähert. Im Gegensatz zur Leitfähigkeitselektrode 3a dient der Sensor 11 dazu, den zugehören Kraftfahrzeugtürverschluss zu verriegeln bzw. zu sichern.

Durch die unterschiedliche topologische Anordnung und die verschieden großen Empfangsbereiche von einerseits dem Sensor 11 und andererseits der Leitfähigkeitselektrode 3a und der Zusatzelektrode 13 wird eine saubere Trennung der einzelnen Funktionalitäten erreicht. Hierzu trägt nicht nur der gleichsam auf die Deckelschale 13 begrenzte Empfangsbereich des Berührungssensors in Gestalt der Deckelschale 13 bei, sondern auch die Tatsache, dass sich die Leitfähigkeitselektrode 3a zumeist im inneren Bereich des Türgriffes bzw. Handgriffes 6 befindet.

Demgegenüber erfasst der Sensor 11 nähernde Bewegungen gleichsam frontseitig des Handgriffes 6, wie dies der strichpunktiert angedeutete Empfangsbereich in der Fig. 8 andeutet. Man erhält also zwei Empfindlichkeitsbereiche für einerseits den Sensor 11 und andererseits die Leitfähigkeitselektrode 3a in Kombination mit der Zusatzelektrode 13, die sich letztlich nicht überlappen und im Kern einerseits durch eine Trennfläche T zwischen der Deckelschale 13 und der Grundschale 14 des Handgriffs 6 und andererseits die Außenhaut der Kraftfahrzeugtür 7 voneinander separiert sind. Folglich ist es für einen Bediener problemlos möglich, die unterschiedlichen und beschriebenen Routinen durch Annäherung seiner Hand 3b an die bestimmten Bereiche auszulösen und voneinander zu unterscheiden.

In der Fig. 8 ist schließlich noch die Möglichkeit angedeutet, den Empfangsbereich der Zusatzelektrode 13 zu verkleinern, und zwar auf einen der Tür zugewandten Sektor. Das geschieht im Detail so, dass die Deckelschale 13 bzw. die dortigen Leitfähigkeitsbahnen unterbrochen werden (gestrichelte Darstellung).

**Patentansprüche**

1. Schlüssellose Betätigungs- und/oder Schließeinrichtung für insbesondere Kraftfahrzeuge, mit

   - einem bedienerspezifischen Datenträger (1), welcher zur Beaufschlagung einer Tür, Klappe oder dergleichen des Kraftfahrzeuges von einer kraftfahrzeugseitigen Steuereinheit (2) abgefragt wird, und mit

   - einem kapazitiven Sensor (3), welcher bei Annäherung des Bedieners die Datenabfrage startet, wobei

   - der Start der Datenabfrage durch Abstand- und/oder Flächenänderungen von Elektroden (3a, 3b) des kapazitiven Sensors (3) erst beim Überschreiten eines vorgegebenen Schwellwertes hervorgerufen wird,

   **dadurch gekennzeichnet,dass**
   der Sensor (3) mit hierauf befindlichen Ladungen ein elektrisches Feld vorgegebener Ausdehnung als Detektionsbereich (D) definiert, innerhalb dessen Kapazitätsänderungen des aus den Elektroden (3a, 3b) gebildeten Kondensators (3a, 3b) erfasst werden, und dass
   der Detektionsbereich (D) einen Auslösebereich (A) umfasst, wobei lediglich innerhalb des Auslösebereiches (A) hervorgerufene Kapazitätsänderungen die Datenabfrage starten.

2. Schlüssellose Betätigungs- und/oder Schließeinrichtung nach Anspruch 1, **dadurch gekennzeichnet, dass** die Elektroden (3a, 3b) des kapazitiven Sensors (3) einerseits als Leitfähigkeitselektrode (3a) und andererseits als sich der Leitfähigkeitselektrode (3a) nähernder menschlicher Körper (3b) ausgebildet sind.

3. Schlüssellose Betätigungs- und/oder Schließeinrichtung nach Anspruch 1 oder 2, **dadurch gekennzeichnet, dass** der menschliche Körper (3b) gegenüber Massepotential (8) eine Kapazität von einigen 100 pF aufweist und über das Massepotential (8) einen geschlossenen elektrischen Stromkreis mit der Leitfähigkeitselektrode (3a) bildet.

4. Schlüssellose Betätigungs- und/oder Schließeinrichtung nach einem der Ansprüche 1 bis 3, **dadurch gekennzeichnet, dass** die Leitfähigkeitselektrode (3a) dielektrisch isoliert in einem Handgriff (6) einer Kraftfahrzeugtür (7) angeordnet ist.

5. Schlüssellose Betätigungs- und/oder Schließeinrichtung nach einem der Ansprüche 1 bis 4, **dadurch gekennzeichnet, dass** das von der Leitfähigkeitselektrode (3a) ausgehende elektrische Feld zur Kraftfahrzeugaußenseite oder -innenseite hin gerichtet und gegebenenfalls abgeschirmt ist.

6.  Schlüssellose Betätigungs- und/oder Schließeinrichtung nach einem der Ansprüche 1 bis 5, **dadurch gekennzeichnet, dass** ein Sensor (11) zum Sichern des Fahrzeuges vorgesehen ist, welcher durch Vorbeistreichen einer Hand des Bedieners ausgelöst wird.

7.  Schlüssellose Betätigungs- und/oder Schließeinrichtung nach einem der Ansprüche 1 bis 6, **dadurch gekennzeichnet, dass** der Handgriff (6) in Seitenansicht zweigeteilt ist, wobei eine dortige Deckelschale (13) für eine Grundschale (14) als Zusatzelektrode (13) in Kombination mit der Leitfähigkeitselektrode (3a) wirkt.

8.  Schlüssellose Betätigungs- und/oder Schließeinrichtung nach einem der Ansprüche 1 bis 7, **dadurch gekennzeichnet, dass** die Empfangsbereiche von einerseits dem Sensor (11) und andererseits der Leitfähigkeitselektrode (3a) sowie ggf. der Zusatzelektrode (13) voneinander separiert sind.

9.  Schlüssellose Betätigungs- und/oder Schließeinrichtung nach einem der Ansprüche 1 bis 8, **dadurch gekennzeichnet, dass** die Kapazitätsänderungen des Kondensators (3a, 3b) durch periodische Lade-/Entladevorgänge ausgewertet werden.

10. Schlüssellose Betätigungs- und/oder Schließeinrichtung nach einem der Ansprüche 1 bis 9, **dadurch gekennzeichnet, dass** durch Umwelteinflüsse bedingte Kapazitätsänderungen des Sensors (3) erfasst und im Sinne einer Rekalibrierung berücksichtigt werden.


**Claims**

1.  A keyless activating and/or locking system, in particular for an automotive vehicle, said system having

    -   an operator-specific data carrier (1) that is sensed by an on board control unit (2) for acting on a door, a gate or the like of the automotive vehicle and having

    -   a capacitive sensor (3) that starts data sampling as the operator approaches,

    -   data sampling being initiated by distance and/or surface variations of electrodes (3a, 3b) of the capacitive sensor (3) only if a prescribed threshold value is exceeded,

    **characterized in that**
    the sensor (3), having charges located thereon, defines as the detection region (D) an electrical field of a given size within which capacitance variations of the capacitor (3a, 3b) formed by the electrodes (3a, 3b) are registered and that
    the detection region (D) includes an enabling region (A), with only the capacity variations that occur within the enabling region (A) initiating data sampling.

2.  The keyless activating and/or locking system in accordance with claim 1, **characterized in that** the electrodes (3a, 3b) of the capacitive sensor (3) are configured to be a conductivity electrode (3a) on the one side and a human body (3b) approaching the conductivity electrode (3a) on the other side.

3.  The keyless activating and/or locking system in accordance with claim 1 or 2, **characterized in that** the human body (3b) has a capacitance to ground potential (8) of some 100 pF and forms, via the ground potential (8), a closed electrical circuit with the conductivity electrode (3a)

4.  The keyless activating and/or locking system in accordance with any of the claims 1 through 3, **characterized in that** the conductivity electrode (3a) is dielectrically insulated and disposed in a handle (6) of an automotive vehicle's door (7).

5.  The keyless activating and/or locking system in accordance with any of the claims 1 through 4, **characterized in that** the electrical field generated by the conductivity electrode (3a) is oriented toward the exterior side of the automotive vehicle or toward the interior side thereof and is shielded at need.

6.  The keyless activating and/or locking system in accordance with any of the claims 1 through 5, **characterized in that** there is provided a sensor (11) for securing the vehicle, said sensor being enabled upon experiencing a touch by the operator's hand.

7.  The keyless activating and/or locking system in accordance with any of the claims 1 through 6, **characterized in that** the handle (6) is divided into two parts when viewed from the side, a cover shell (13) for a base shell (14) being provided there and acting, in combination with the conductivity electrode (3a), as an additional electrode (13).

8.  The keyless activating and/or locking system in accordance with any of the claims 1 through 7, **characterized in that** the reception regions of the sensor (11) on the one side and of the conductivity electrode (3a) on the other side and, if applicable, of the additional electrode (13) are separated from one another.

9. The keyless activating and/or locking system in accordance with any of the claims 1 through 8, **characterized in that** the capacitance variations of the capacitor (3a, 3b) are evaluated by periodic charging and discharging.

10. The keyless activating and/or locking system in accordance with any of the claims 1 through 9, **characterized in that** capacitance variations of the sensor (3) that are due to environmental influences are registered and taken into account for recalibration.

**Revendications**

1. Système d'actionnement et/ou de verrouillage sans clé, notamment pour véhicule automobile, avec

   - un support de données (1) spécifique à l'utilisateur qui est lu par une unité de contrôle (2) embarquée en vue d'agir sur une porte, un hayon ou similaire du véhicule automobile et avec

   - un capteur capacitif (3) qui initie la lecture des données à l'approche d'un utilisateur,

   - la lecture des données n'étant initiée par des variations de distance et/ou de surface d'électrodes (3a, 3b) du capteur capacitif (3) que lorsqu'un seuil donné est dépassé,

   **caractérisé en ce que**
   le capteur (3) comportant des charges définit un champ électrique d'une étendue donnée, ce champ électrique faisant office de zone de détection (D) au sein de laquelle sont enregistrées des variations de capacité du condensateur (3a, 3b) formé par les électrodes (3a, 3b) et que
   la zone de détection (D) comprend une zone de déclenchement (A), seules les variations de capacité ayant lieu au sein de la zone de déclenchement (A) initiant la lecture des données.

2. Système d'actionnement et/ou de verrouillage sans clé selon la revendication 1, **caractérisé en ce que** les électrodes (3a, 3b) du capteur capacitif (3) constituent d'une part une électrode de conductivité (3a) et d'autre part un corps humain (3b) s'approchant de l'électrode de conductivité (3a).

3. Système d'actionnement et/ou de verrouillage sans clé selon la revendication 1 ou 2, **caractérisé en ce que** le corps humain (3b) a une capacité de l'ordre de quelques 100 pF par rapport au potentiel de masse (8) et qu'il forme avec l'électrode de conductivité (3a), par l'intermédiaire du potentiel de masse (8), un circuit électrique fermé.

4. Système d'actionnement et/ou de verrouillage sans clé selon l'une quelconque des revendications 1 à 3, **caractérisé en ce que** l'électrode de conductivité (3a) est montée, isolée diélectriquement, dans une poignée (6) d'une porte (7) de véhicule automobile.

5. Système d'actionnement et/ou de verrouillage sans clé selon l'une quelconque des revendications 1 à 4, **caractérisé en ce que** le champ électrique se propageant à partir de l'électrode de conductivité (3a) est orienté vers l'extérieur ou vers l'intérieur du véhicule automobile et est blindé le cas échéant.

6. Système d'actionnement et/ou de verrouillage sans clé selon l'une quelconque des revendications 1 à 5, **caractérisé en ce qu'**il est prévu un capteur (11) destiné à bloquer le véhicule, lequel capteur est déclenché lorsqu'il est effleuré par la main de l'utilisateur.

7. Système d'actionnement et/ou de verrouillage sans clé selon l'une quelconque des revendications 1 à 6, **caractérisé en ce que**, vue de côté, la poignée (6) est divisée en deux parties, une coque formant couvercle (13) pour une coque de base (14) y étant prévue et faisant office, combinée avec l'électrode de conductivité (3a), d'électrode supplémentaire (13).

8. Système d'actionnement et/ou de verrouillage sans clé selon l'une quelconque des revendications 1 à 7, **caractérisé en ce que** les zones de réception du capteur (11) d'une part et de l'électrode de conductivité (3a) d'autre part ainsi que, le cas échéant, de l'électrode supplémentaire (13) sont séparées les unes des autres.

9. Système d'actionnement et/ou de verrouillage sans clé selon l'une quelconque des revendications 1 à 8, **caractérisé en ce que** les variations de capacité du condensateur (3a, 3b) sont évaluées par des cycles successifs de charge et de décharge.

10. Système d'actionnement et/ou de verrouillage sans clé selon l'une quelconque des revendications 1 à 9, **caractérisé en ce que** des variations de capacité du capteur (3) dues à des facteurs environnementaux sont enregistrées et prises en considération en termes de recalibrage.

Fig.1

Fig.2

Fig.3

Fig.4

Fig.5

Fig.6

Fig.7

Fig.8